# EUROPEAN PATENT APPLICATION

(11) **EP 0 902 463 A1**
(43) Date of publication of application: **17.03.1999**
(21) Application number: 97830433.5
(22) Date of filing: 29.08.1997
(51) Int. Cl.: H01L 21/321, H01L 21/8247

(54) **Method for forming a plurality of parallel floating gate regions by avoiding poly stringers formation**

(71) Applicant: STMicroelectronics S.r.l., 20041 Agrate Brianza (Milano) (IT)
(72) Inventor: Brambilla, Claudio, 20049 Concorezzo (Milano) (IT); Cereda, Manlio Sergio, 22050 Lomagna (Lecco) (IT); Caprara, Paolo, 20100 Milano (MI) (IT); Cassio, Valerio, 12030 Polonghera (Cuneo) (IT); Wurthwein, Arturo, 24027 Nembro (Bergamo) (IT)
(74) Representative: Botti, Mario

(57) **Abstract**

A method of manufacturing a plurality of floating gate regions lying parallel on a semiconductor substrate (10), and of inhibiting the formation of residue materiallaterally contiguous to each floating gate region, comprises the following steps: growing a thin oxide layer (13) over the semiconductor substrate (10); depositing a first layer (14) of polysilicon to fully cover the first thin oxide layer; growing and/or depositing an intermediate dielectric layer (15) over the first layer (14) of polysilicon; depositing a second layer (16) of polysilicon to fully cover the intermediate dielectric layer (15). This method further comprises the steps of depositing a final dielectric layer (17) to cover the previously deposited and/or grown layers (13,14,15,16); depositing a layer of resist onto the final dielectric layer, followed by a photolithographing step to define a planar geometry bounding the floating gate regions; and carrying out a first etching to only transfer this planar geometry onto the final dielectric layer (17), thereby producing a mask for a late second etching of the self-aligned type; thoroughly removing the layer of resist; carrying out a second self-aligned etching to spatially define the floating gate regions with a vertical profile.

## Description

### Field of the Invention

This invention relates to a method of manufacturing a plurality of floating gate regions lying parallel on a semiconductor substrate, while inhibiting the formation of so-called poly stringers.

More particularly, the invention is a method comprising the following steps:
growing a thin oxide layer over the semiconductor substrate;
depositing a first layer of polysilicon to fully cover the first thin oxide layer;
growing and/or depositing an intermediate dielectric layer over the first layer of polysilicon; and
depositing a second layer of polysilicon to fully cover the intermediate dielectric layer.

The invention also relates to a semiconductor substrate integrated electronic device, and to a matrix type of memory device, such as a ROM, EPROM or EEPROM, both obtained by the method of this invention.

The invention specifically concerns a self-aligned etching process for defining floating gate regions while inhibiting the formation of residue materiallaterally contiguous to each floating gate region. The description that follows is making reference to this field of application for convenience of illustration.

### Background Art

As is well known, electronic memory devices of the EPROM or FLASH-EPROM type involve the formation of a matrix-like layout on a semiconductor substrate, wherein a plurality of bit lines, associated with floating gate regions, are crossed over by a plurality of conductive strips, or word lines.

The practical completion of this matrix-like layout is not devoid of difficulties and drawbacks, since it has been found experimentally that the floating gate regions may be placed in mutual electric contact by spurious residue of the conductive material that failed to be thoroughly removed during the manufacturing process.

For the aspects of this invention to be fully appreciated, the process steps involved in defining, on a semiconductor substrate, a matrix-like layout of an EPROM memory device comprising word lines, bit lines, and floating gate regions, will be briefly reviewed herein below.

This analysis will also be useful to highlight essential aspects for correctly framing the technical problem that the invention is directed to solve.

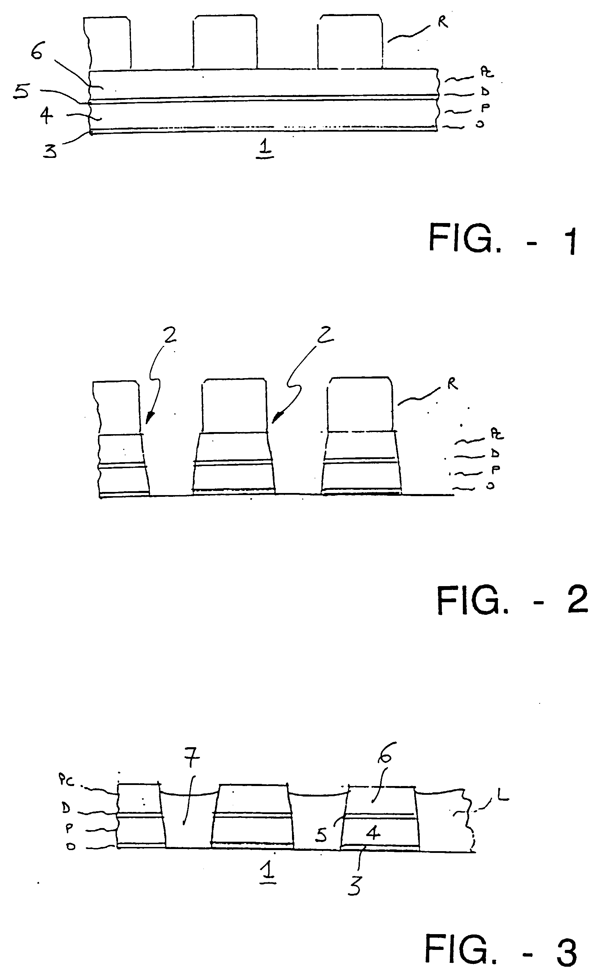

Referring to Figure 1 of the accompanying drawings, and starting from a semiconductor substrate 1 that has already been divided into active areas, one proceeds in multiple depositions until a stack structure, as described hereinafter, is formed over the entire surface of the substrate.

The first, deposited and/or grown, layer is a thin gate oxide layer 3. Subsequently, a first layer 4 of polysilicon, designated the POLY1, is deposited and/or grown, followed by the deposition of a second dielectric layer 5 of the interpoly type, e.g. of ONO, which is then capped with a third polysilicon layer 6, the latter being designated the POLYCAP.

At this stage, a photolithographing step, carried out with the aid of a suitable mask of resist, allows to define a layout of the gate regions which extend parallel across the substrate spacing from one another.

This layout is then transferred onto the underlying stack structure by a successive etching step.

In particular, this etching step is carried out in cascade and a self-aligned manner, resulting in removal of material from the stack structure.

In this way, a circuit architecture is defined which stands out of the semiconductor substrate 1, and wherein a plurality of active elements can be recognized extending as parallel discrete stripes associated with floating gate regions.

Thus, the gate regions 2 will be formed of the POLYCAP-ONO-POLY1-gate oxide stack structure.

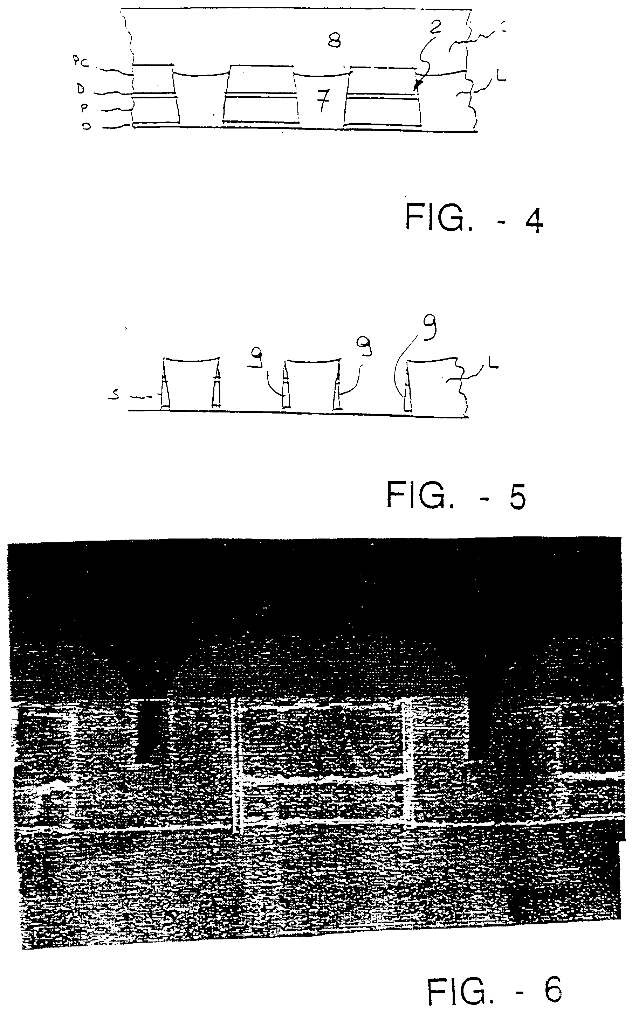

A self-aligned etching step carried out through several layers, as shown in Figure 2, results in floating gate regions 2 being formed which have a trapezoid-like outline in cross-section, due to the presence of residue materialwhich has not been fully etched away along the floating gate sides.

A closer examination of the process that leads to the formation of such residue has revealed that this is mainly created by the dry etching applied to remove the polysilicon layers, POLYCAP and POLY1, included in the stack structure.

In fact, chemical reactants are used during these dry etching steps which interact with the resist, to release polymers which gradually settle along the side of the polycrystalline layer just etched.

Another cause for the formation of the aforementioned residue is the so-called poly stringers, which originate during an additional oxidising step usually applied to seal off the floating gate regions. During this oxidation, the POLYCAP layer 6 is re-oxidised more than the POLY1 layer 4, thereby promoting the formation of the floating gate regions with a stepped profile.

Situations such as these, where the floating gate regions are given a stepped or trapezoid-like profile, may be at the origin of short circuits between adjacent memory cells, once the final architecture of the memory device is settled by a self-aligned etching operation to define the word lines.

The next process steps in the manufacturing of the EPROM memory device include removal of the resist left over to protect the floating gate regions and a planarizing step.

The planarizing step starts with the filling of the gaps between adjacent floating gate regions with a dielectric layer 7,

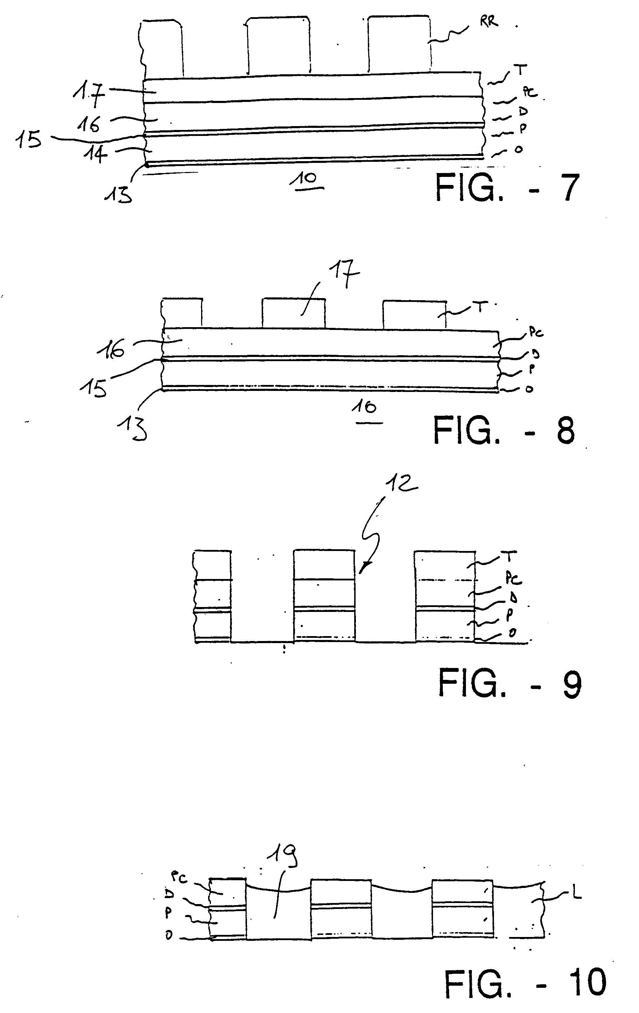

The manufacturing process continues with the formation of the plurality of word lines which cross the floating gate regions 2 orthogonally. This step involves the deposition of a conductive layer 8 to fully cover the planarized architecture shown in Figure 4.

To define the spatial geometry of the word lines, a conventional photolithographing step is again applied using a suitable mask of resist to appoint as unprotected those areas where one or more self-sligned etchings can be effected to also define the individual memory cells.

This etching step leads to removing, in this order: the conductive layer 8, POLYCAP polysilicon layer 6, ONO interpoly dielectric layer 5, and POLY1 polysilicon layer 4.

Figure 5 is a vertical cross-section view of a circuit architecture manufactured by a conventional method, wherein a region between two adjacent word lines is shown after the etching step for defining the word lines.

It is important to observe that the dielectric layer in the gaps acts as a micro-mask protecting the poly stringers.

Also noticeable in this figure is the presence of the stringer 9 protected by the planarizing dielectric layer 7, with the latter being only partially etched away by the aforementioned etching step.

The conventional method described above yields a matrix-like layout on the semiconductor substrate which comprises gate regions crossed orthogonally by word lines. This layout is extensively employed for memory devices of the EPROM or E²PROM type, and especially for "checkerboard" or crosspoint memories, but shows certain critical aspects requiring care.

It has been stated hereinabove that the presence of stringers along the sides of the floating gate regions can impair the reliability of a memory device.

In fact, this spurious residue of material can be the cause of short circuits between adjacent memory cells.

The underlying technical problem of this invention is to provide a self-aligned etching method for definining floating gate regions, which can inhibit the formation of residue materialknown as "stringers", and accordingly, improve the reliability of memory devices manufactured with such circuit architectures.

### Summary of the Invention

The solution idea behind this invention is one of utilizing a substitute for the resist mask usually employed for guiding a self-aligned etching directed to define floating gate regions, while avoiding the use of materials which could promote the formation of polymers.

Based on this idea, the technical problem is solved by a method as previously indicated and defined in the characterizing portion of Claim 1.

The problem is also solved by an electronic memory device having a matrix-like structure, as previously indicated and defined in Claim 5.

The features and advantages of the method and the device according to the invention can best be appreciated by reading the following description of exemplary and non-limitative embodiments thereof, in conjunction with the accompanying drawings.

### Brief Description of the Drawings

In the drawings:
Figures 1 to 5 are enlarged vertical section views showing schematically a portion of a semiconductor substrate involved by successive steps of a process which result in the formation of a plurality of floating gate regions for a conventional electronic memory device;
Figure 6 reproduces an electron microphotograph of a semiconductor substrate whereto a circuit architecture according to the invention has been integrated; and
Figures 7 to 10 are enlarged vertical section views, respectively showing in schematic form a portion of a semiconductor substrate involved by successive steps of a process according to the invention which result in the formation of a plurality of floating gate regions.

### Detailed Description

Referring to the drawings, in particular to the example of Figure 6, a preferred embodiment of the inventive method will be described which is effective to inhibit the creation of poly stringers during the formation of the floating gate regions.

This method conventionally provides for the formation, over a semiconductor substrate 10, of a sandwich type of stack structure 12 wherein conductive materials alternate with insulating materials.

This structure is obtained by the steps of:
growing a thin oxide layer 13 over the semiconductor substrate 10;
depositing a first polysilicon layer 14 to fully cover the thin oxide layer;
growing and/or depositing an intermediate dielectric layer 15 over the first polysilicon layer 14; and
depositing a second polysilicon layer 16 to fully cover the intermediate dielectric layer 15.

Advantageously in the method according to the invention, a final dielectric layer 17 is also deposited to cover the layers previously deposited and/or grown. This dielectric layer 17 may be a layer of silicon oxide, for example, or a material other than polysilicon which would not promote the formation of polymers.

Specifically, this layer 17 is selected to have a different etch rate from that of the polysilicon layers 14 and 16.

The final dielectric layer is then covered with a layer 18 of resist preliminarly to a photolithographing step for defining a planar geometry.

This planar geometry bounds the extent of the floating gate regions on the semiconductor substrate 10.

Thereafter, a first etching step is carried out to only transfer this planar geometry onto the final dielectric layer 17.

The resist layer 18 left for protection is then removed, because of its function being now served by the final dielectric layer 17.

This layer 18 of resist may be removed at some later stage, if desired.

At this point, a self-aligned etching step can be carried out in cascade to etch away, from the unprotected areas by the final dielectric layer 17, the material which makes up the stack structure.

Advantageosuly in this invention, the profile of the gate regions achieved with the second anisotropic etching step will be truly vertical, and no longer trapezoidal in shape or stepped as in devices produced by conventional methods.

Thus, the method of this invention inhibits the formation of residue materiallaterally of the floating gate regions, i.e. the so-called stringers of polysilicon, as the second self-aligned etching step is carried out to define the floating gate regions spatially.

Advantageously, the final dielectric layer 17 would be patterned, by the first etching step, as a mask for the next self-aligned etching step.

The use of this dielectric mask prevents the chemicals used during the second etching step, for removing the first and second polysilicon, from reacting with the resist and, accordingly, forming stringers along the sides of the gate regions.

The teachings given thus far for integrating an electronic memory device having floating gate regions laid parallel across the substrate to a semiconductor are specially useful where a crosspoint matrix type of memory device is to be produced.

In fact, whereas the stringers may be the cause for short circuits between adjacent memory cells, no stringers affect the memory cells yielded by the inventive method.

The method described is completed by further process steps directed to turn the stringer-free floating gate regions into a matrix memory device.

For the purpose, a planarizing dielectric layer 19 should be deposited in the substrate regions included between adjacent gate regions to allow of the later deposition of an overlying conductive layer.

This is followed by a photolithographing step for defining the layout of conductive strips, referred to as the word lines and crossing the floating gate regions orthogonally.

The final step is one of self-aligned etching to spatially define word lines, and hence the memory cells.

This final step consists of etching, away from the unprotected areas against photolithographic attack, the materials belonging to the conductive layer, the second layer 16 of polysilicon, the intermediate dielectric layer 15, and the first layer 14 of polysilicon.

Figure 6 reproduces an electron micro-photograph of a semiconductor substrate whereto a matrix-like circuit architecture according to the invention has been integrated, demonstrating the complete absence of stringers.

In summary, the method of this invention can inhibit the formation of stringers laterally contiguous to each floating gate region integrated to the semiconductor substrate.

This teaching is specially useful to the manufacturing of matrix memory devices of substantially improved reliability.

## Claims

1. A method of manufacturing a plurality of floating gate regions lying parallel on a semiconductor substrate (10), and of inhibiting the formation of residue material laterally contiguous to each floating gate region, which method comprises the following steps:
growing a thin oxide layer (13) over the semiconductor substrate (10);
depositing a first layer (14) of polysilicon to fully cover the first thin oxide layer;
growing and/or depositing one or more intermediate dielectric layers (15) over the first layer (14) of polysilicon; and
depositing a second layer (16) of polysilicon to fully cover the intermediate dielectric layer (15); characterized in that it further comprises the steps of:
depositing a final dielectric layer (17) to cover the previously deposited and/or grown layers (13,14,15,16);
depositing a layer of resist onto said final dielectric layer, followed by a photolithographing step to define a planar geometry bounding the floating gate regions;
carrying out a first etching to only transfer said planar geometry onto the final dielectric layer (17), thereby producing a mask for a late second etching of the self-aligned type;
thoroughly removing the layer of resist;
carrying out a second self-aligned etching to define the floating gate regions spatially.

2. A method of manufacturing a plurality of floating gate regions according to Claim 1, characterized in that the etch rate for said final dielectric layer (17) is different from that for the polysilicon layers (14,16).

3. A method of manufacturing a plurality of floating gate regions according to Claim 1, characterized in that said final dielectric layer (17) is silicon oxide.

4. A method of manufacturing a plurality of floating gate regions according to Claim 1, comprising additional steps for defining a plurality of word lines crossing the floating gate regions orthogonally.

5. A crosspoint matrix type of electronic memory device integrated to a semiconductor substrate, as obtained by the method of Claim 1.
